# EUROPÄISCHE PATENTANMELDUNG

(11) **EP 1 365 517 A2**
(43) Veröffentlichungstag der Anmeldung: **26.11.2003**
(21) Anmeldenummer: 03011577.8
(22) Anmeldetag: 22.05.2003
(51) Int. Cl.: H04B 1/04, H04L 27/00

(54) **Eingangsschaltung für einen HF-Sendebaustein**

(30) Priorität: 25.05.2002 DE 10223396
(71) Anmelder: Diehl AKO Stiftung & Co. KG, 88239 Wangen (DE)
(72) Erfinder: Sebald, Marc, 91236 Alfeld (DE); Werner, Wolfgang, 90556 Cadolzburg/Wachendorf (DE); Zimmermann, Jürgen, 90453 Nürnberg (DE)
(74) Vertreter: Diehl Patentabteilung

(57) **Zusammenfassung**

Eine Eingangsschaltung für einen HF-Sendebaustein 1 eines batteriebetriebenen Geräts zur Übertragung eines Datensignals soll den Stromverbrauch reduzieren. Hierfür ist die Grundfrequenz eines Referenzoszillators 5 mit dem digitalen Datensignal moduliert, wobei die Datenrate größer als 20 kchip/s ist. Zur Glättung des modulierten Referenzsignals ist zwischen den Referenzoszillator 5 und den HF-Sendebaustein 1 ein Amplitudenbegrenzer 11 und ein Bandpassfilter 15 geschaltet.

## Beschreibung

Die Erfindung betrifft eine Eingangsschaltung für einen integrierten HF-Sendebaustein eines batteriebetriebenen Geräts zur Übertragung eines Datensignals, wobei ein Referenzoszillator an einen der Eingänge des Sendebausteins angeschlossen ist.

Derartige batteriebetriebene Geräte sind beispielsweise Verbrauchsmessgeräte, die zyklisch dem jeweiligen Verbrauchsstand entsprechende Funksignale senden, um den Verbrauchsstand für eine Verbrauchsabrechnung von ausserhalb des Gebäudes oder Raumes, in dem der Verbrauch stattfindet, erfassen zu können. Solche Verbrauchsmessgeräte können zur Erfassung des mittels eines Wasserzählers gemessenen Wasserverbrauchs oder des Wärmeverbrauchs an Heizkörpern oder des Stromverbrauchs dienen. Die Verbrauchsmessgeräte sollen kleinbauend und über mehrere Jahre wartungsfrei sein. Für den Betrieb solcher Geräte sind z. B. Funkfrequenzen von 433 MHz, 868 MHz und 915 MHz (USA ) freigegeben.

Als kostengünstiger HF-Sendebaustein ist der ASK/FSK-Transmitter 868/433 MHz TDA5100 oder TDA5102 (USA-Version) bzw. die TDA51xx-Familie der Fa. Infineon Technologys AG bekannt. Ähnliche Bausteine sind auch von anderen Herstellern bekannt. Bei der üblichen Beschaltung des Sendebausteins mit einem Referenzoszillator ist die übertragbare Datenrate auf etwa 20 kchip/s begrenzt. Dies ist ungünstig. Denn je niedriger die Datenrate ist, desto länger werden die Datentelegramme und desto größer wird der Stromverbrauch bei der Sendung der Datentelegramme. Ein hoher Stromverbrauch ist ungünstig, weil das batteriebetriebene Gerät jahrelang arbeiten soll, ohne dass die Batterien ausgetauscht oder nachgeladen werden müssen.

Aufgabe der Erfindung ist es, eine Eingangsschaltung der eingangs genannten Art vorzuschlagen, bei der die übertragene Datenrate sehr hoch gewählt werden kann.

Erfindungsgemäß ist obige Aufgabe durch die Merkmale des kennzeichnenden Teils des Anspruchs 1 gelöst.

Durch die hohe Datenrate ist erreicht, dass die, beispielsweise eine Kennung und einen Zählerstand beinhaltenden, Datentelegramme jeweils sehr kurz dauern. Ihre Sendung verbraucht also entsprechend wenig Strom der Batterie. Um zugewährleisten, dass trotz der hohen Datenrate der bekannte HF-Sendebaustein zuverlässig arbeitet, wird die Amplitude des modulierten Datensignals begrenzt. Dadurch sind Spannungsspitzen und Spannungsschankungen des frequenzmodulierten Datensignals unterdrückt. Das Bandpassfilter hält störende Oberwellen und Schwebungen des modulierten Datensignals vom HF-Sendebaustein fern.

In weiterer Ausgestaltung der Erfindung ist das Datensignal über ein Vorfilter an den Referenzoszillator gelegt, das die Flankensteilheit des Datensignals verringert. Durch die verringerte Flankensteilheit sind Oberwellen des digitalen Datensignals schon vor dem Referenzoszillator unterdrückt.

Weitere vorteilhafte Ausgestaltungen der Erfindung ergeben sich aus den Unteransprüchen und der folgenden Beschreibung eines Ausführungsbeispiels. In der Zeichnung zeigen:

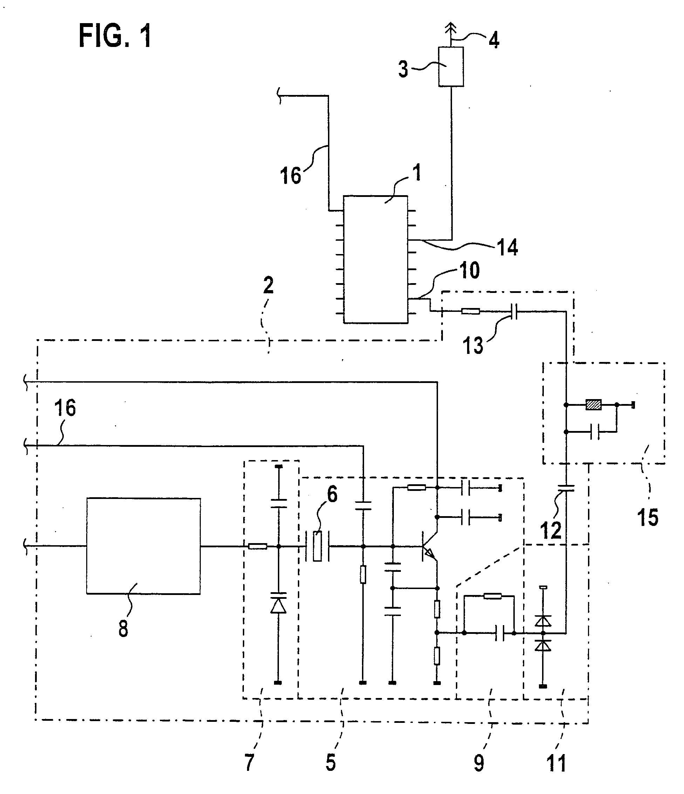

Figur 1 ein Blockschaltbild eines HF-Sendebausteins mit Eingangsschaltung,
Figur 2 Spannungsdiagramme, wobei zeigen:
Fig. 2a einen Teil eines digitalen Datensignals,
Fig. 2b dieses vorgefiltert,
Fig. 2c ein frequenzmoduliertes Referenzsignal,
Fig. 2d dieses amplitudenbegrenzt und
Fig. 2e dieses bandbreitenbegrenzt

Der HF-Sendebaustein 1 ist der eingangs genannte TDA5100, an dessen Eingang 10 eine Eingangsschaltung 2 und an dessen Ausgang 14 eine Ausgangsschaltung 3 mit Antennenverstärker und Sendeantenne 4 liegt.

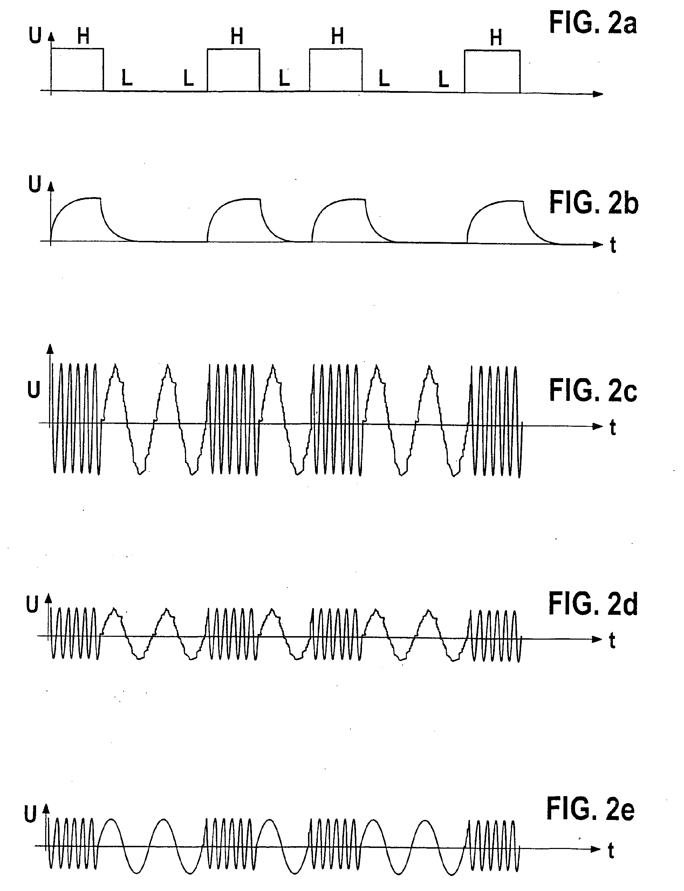

Die Eingangsschaltung 2 weist einen Referenzoszillator 5 auf, der als Colpitts-Oszillator aufgebaut ist. Er arbeitet mit einer Grundfrequenz von 6,788 MHz. An seinem Schwingquarz 6 ist eine Modulationseinrichtung 7 angeschlossen, die mit einer Kapazitätsdiode arbeitet. An diese ist über ein Vorfilter 8 das digitale Datensignal (vgl. Fig. 2a) gelegt, das beispielsweise von einem Mikrocontroller kommt, der dieses aus einem Messwert erzeugt.

Am Ausgang des Referenzoszillators 5 liegt über ein Koppelglied 9 ein Amplitudenbegrenzer 11 mit zwei Dioden. Zwischen den Amplitudenbegrenzer 11 und den Eingang 10 ist über weitere Koppelglieder 12,13 ein Bandpassfilter 15 geschaltet.

Das Datensignal ist ein binäres Signal mit einer 3- aus 6-Kodierung. Seine Datenrate beträgt 100 kchip/s. Die Figur 2a zeigt nur einen Teil des Datensignals.

Das Vorfilter 8 verringert die Flankensteilheit des digitalen Datensignals (vgl. Fig. 2b). Mit dem gefilterten Datensignal wird die Grundfrequenz, beispielsweise 6,788 MHz, des Referenzoszillators 5 derart moduliert, dass beim Spannungspegel H des Datensignals die Frequenz höher ist als beim Spannungspegel L des Datensignals (vgl. Fig. 2c). Dieses modulierte Signal ist noch von Spannungsspitzen und Oberwellen überlagert. Um die Spannungsspitzen zu unterdrücken, reduziert der Amplitudenbegrenzer 11 die Amplitude des frequenzmodulierten Referenzsignals, beispielsweise auf +/- 300 bis 600 mV (vgl. Fig. 2d).

Das eine Spule und einen Kondensator aufweisende Bandpassfilter 15 begrenzt die Bandbreite des modulierten Referenzsignals, um Oberwellen und Schwebungen vor dem Eingang 10 des HF-Sendebausteins 1 zu unterdrücken. Das Bandpassfilter 15 begrenzt die um die Grundfrequenz von etwa 6,788 MHz liegende Bandbreite auf etwa 500 kHz (vgl. Fig. 2e). Damit ist das modulierte Referenzsignal derart geglättet, dass es vom HF-Sendebaustein 1 trotz hoher Datenrate störungsfrei verarbeitet werden kann.

Der HF-Sendebaustein 1 arbeitet mit einer Trägerfrequenz von 868,95 MHz. Diese Trägerfrequenz ist um den Faktor 128 höher als die Grundfrequenz des Referenzoszillators 5. Im HF-Sendebaustein 1 ist ein PLL-Teiler (Phase-Locked-Loop-Divider) mit dem Teilerfaktor 128 vorgesehen. Im HF-Sendebaustein 1 wird die interne Frequenz von 868,95 MHz über den Teiler auf die Grundfrequenz von 6,788 MHz des Referenzoszillators 5 herabgesetzt und dann mit dem am Eingang 10 anstehenden frequenzmodulierten Referenzsignal verglichen. Entsprechend des Vergleichs wird die Sendefrequenz von 868,95 MHz geregelt, so dass am Ausgang 14 und damit an der Sendeantenne 4 ein entsprechend des ursprünglichen Datensignals (vgl. Fig. 2a) moduliertes Sendesignal auftritt.

Zur Stromersparnis sind der HF-Sendebaustein 1 und der Referenzoszillator 5 nicht ständig eingeschaltet, sondern werden vom genannten Mikrocontroller nur zyklisch eingeschaltet. Beispielsweise erfolgt das Einschalten über Einschaltleitungen 16 alle 4 s für 4 ms. Nur in diesen kurzen Zeitfenstem erfolgt eine Sendung des Datensignals. Es hat sich gezeigt, dass diese kurzen Sendezeiten genügen, um Zählerstände derart auszusenden, dass sie in einem einen entsprechenden Empfänger mitführenden Fahrzeug empfangen werden können. Es ist damit eine Zählerstandsablesung von außerhalb der Gebäude bzw. Räume, in denen der Verbrauch stattfindet, auf einfache Weise möglich.

## Patentansprüche

1. Eingangsschaltung für einen integrierten HF-Sendebaustein eines batteriebetriebenen Geräts zur Übertragung eines Datensignals, wobei ein Referenzoszillator an einen der Eingänge des HF-Sendebausteins angeschlossen ist,
**dadurch gekennzeichnet,**
**dass** die Grundfrequenz des Referenzoszillators (5) mit dem digitalen Datensignal moduliert ist, wobei die Datenrate größer als 20 kchip/s ist, und dass zwischen den Referenzoszillator (5) und den HF-Sendebaustein (1) ein Amplitudenbegrenzer (11) und ein Bandpassfilter (15) geschaltet ist.

2. Eingangsschaltung nach Anspruch 1,
**dadurch gekennzeichnet,**
**dass** der Amplitudenbegrenzer (11) die Amplitude des frequenzmodulierten Datensignals auf etwa +/- 600 mV begrenzt.

3. Eingangsschaltung nach Anspruch 1,
**dadurch gekennzeichnet,**
**dass** das Bandpassfilter (15) die Bandbreite des frequenzmodulierten Datensignals auf etwa 500 kHz begrenzt.

4. Eingangsschaltung nach einem der vorhergehenden Ansprüche,
**dadurch gekennzeichnet,**
**dass** das digitale Datensignal über ein Vorfilter (8) an den Referenzoszillator (5) gelegt ist, das die Flankensteilheit des Datensignals verringert.

5. Eingangsschaltung nach einem der vorhergehenden Ansprüche,
**dadurch gekennzeichnet,**
**dass** das digitale Datensignal über eine eine Kapazitätsdiode aufweisende Modulationseinrichtung (7) an den Referenzoszillator (5) gelegt ist.

6. Eingangsschaltung nach einem der vorhergehenden Ansprüche,
**dadurch gekennzeichnet,**
**dass** der Referenzoszillator (5) ein Colpitts-Oszillator ist.

7. Eingangsschaltung nach einem der vorhergehenden Ansprüche,
**dadurch gekennzeichnet,**
**dass** die Grundfrequenz des Referenzoszillators (5) kleiner als die Sendefrequenz des HF-Sendebausteins (1) ist.

8. Eingangsschaltung nach Anspruch 7,
**dadurch gekennzeichnet,**
**dass** die Grundfrequenz des Referenzoszillators (5) etwa 6,788 MHz ist.

9. Eingangsschaltung nach einem der vorhergehenden Ansprüche 7, 8,
**dadurch gekennzeichnet,**
**dass** die Sendefrequenz des HF-Sendebausteins (1) bei 868,95 MHz liegt.

10. Eingangsschaltung nach einem der vorhergehenden Ansprüche,
**dadurch gekennzeichnet,**
**dass** die Datenrate 50 bis 120 kchip/s, insbesondere 100 kchip/s, beträgt.

11. Eingangsschaltung nach einem der vorhergehenden Ansprüche,
**dadurch gekennzeichnet,**
**dass** der HF-Sendebaustein (1) und der Referenzoszillator (5) zyklisch ein- und ausgeschaltet werden.

12. Eingangsschaltung nach Anspruch 11,
**dadurch gekennzeichnet,**
**dass** der HF-Sendebaustein (1) und der Referenzoszillator (5) etwa alle 4 s für 4 ms eingeschaltet sind.
